# EUROPÄISCHE PATENTSCHRIFT

(11) **EP 3 702 483 B1**
(45) Veröffentlichungstag und Bekanntmachung des Hinweises auf die Patenterteilung: **11.05.2022**
(21) Anmeldenummer: 19159429.0
(22) Anmeldetag: 26.02.2019
(51) Int. Cl.: C22C 27/04, C30B 15/10, C22C 1/05, F27B 14/10, C22C 1/04

(54) **FORMKÖRPER AUS EINER MOLYBDÄN-ALUMINIUM-TITAN-LEGIERUNG**
MOULDED BODY MADE FROM A MOLYBDENUM-ALUMINIUM-TITANIUM ALLOY
ARTICLE MOULÉ D'UN ALLIAGE DE MOLYBDÈNE-ALUMINIUM-TITANE

(43) Veröffentlichungstag der Anmeldung: 02.09.2020
(73) Patentinhaber: Heraeus Deutschland GmbH & Co. KG, 63450 Hanau (DE)
(72) Erfinder: HERBST, Stephan, 63450 Hanau (DE); SPANIOL, Bernd, 63450 Hanau (DE)
(74) Vertreter: Schultheiss & Sterzel Patentanwälte PartG mbB

(56) Entgegenhaltungen:
- WO-A1-2014/148157
- WO-A1-2016/025968
- JP-A- S60 200 980

## Beschreibung

Die Erfindung betrifft einen Formkörper aus einer Molybdänbasislegierung. Die Erfindung betrifft auch ein Verfahren zur Herstellung eines solchen Formkörpers und die Verwendung eines solchen Formkörpers.

In der Kristallzucht von Oxiden oder anderen chemisch aggressiven Materialien aus der Schmelze bei hohen Temperaturen werden Tiegel verwendet, die vollständig oder hauptsächlich aus Iridium bestehen. Solche Tiegel sind beispielsweise aus der US 2016/0303631 A1, der JP 2014 012 613 A, der US 2013/0087094 A1 und der JP 2018 059 165 A bekannt. Das Material Iridium ist sehr teuer geworden. Die JP 2017 222 537 A schlägt vor, die Teile eines Formkörpers aus Iridium, die nicht mit den chemisch aggressiven Schmelzen in Kontakt kommen, durch kostengünstigeres Molybdän zu ersetzen. Reine Molybdäntiegel oder reine Wolframtiegel können auch verwendet werden, setzen aber einen komplizierten Anlagenaufbau voraus. Ein solcher Tiegel ist beispielsweise aus der US 2017/0191188 A1 bekannt. Dabei ist bei Molybdäntiegeln unter anderem nachteilig, dass das Tiegelmaterial durch Abdampfen von Molybänoxid durch der Oxidation von Molybdän und Luftsauerstoff geschwächt wird und so dessen Haltbarkeit eingeschränkt ist. Neben Tiegeln wird Iridium auch gerne zur Herstellung von Kristallisationskeimen und anderen Formkörpern verwendet, die mit Schmelzen bei hohen Temperaturen in Kontakt kommen. Ferner werden auch Heizelemente aus Iridium verwendet, um unter Luftsauerstoff arbeitende Hochtemperatur-Öfen herzustellen. Auch für derartige Anwendungen besteht aufgrund des hohen Preises für Iridium ein Bedürfnis, kostengünstigere Möglichkeiten zu finden. Hinzu kommt, dass Iridium nur sehr schwer verarbeitet werden kann, was die Herstellungskosten von Formkörpern aus Iridium weiter verteuert.

Aus der WO 2016/025968 A1 ist ein Sputter-Target aus einer Molybdänbasislegierung enthaltend Aluminium und Titan bekannt. Das Sputter-Target wird durch Kaltgasspritzen einer Pulvermischung auf ein geeignetes Trägermaterial hergestellt. Aus der Publikation "Oxidation and wet etching behavior of sputtered Mo-Ti-Al films" von Tanjy Jörg et al. in Journal of Vacuum Science & Technology A 36(2), Mar/Apr 2018, publiziert von der American Vacuum Society ist die Herstellung eines gesputterten Dünnfilms aus Mo_{1-x-y}TiₓAl_{y} bekannt. Darin wird von einer schützenden Al₂O₃-Oberflächenschicht berichtet, die sich ab einem Aluminiumgehalt von wenigstens 16 at% bildet.

Dieser Stand der Technik bezieht sich also auf die Herstellung eines Gemischs mittels pulvermetallurgischen Metallgemischen und Oberflächenabscheidungen (Sputtern). Diese werden dann als Barriere in Dünnschichttransistoren verwendet und liegen daher dem auf Tiegel und anderen Formkörpern als Bulkmaterialien fern. Tiegel können nicht über Dünnschichttechniken stabil hergestellt werden. Formkörper können also nicht wirtschaftlich mit Hilfe der bekannten Dünnfilm- oder Dickfilmtechniken als Bulk-Materialien hergestellt werden.

Die Aufgabe der Erfindung besteht also darin, die Nachteile des Stands der Technik zu überwinden. Insbesondere soll ein Formkörper und ein Verfahren zur Herstellung eines Formkörpers bereitgestellt werden, der als Tiegel für die Kristallzucht ähnlich wie Iridium geeignet ist oder der als Bulkmaterial für einen Hochtemperatureinsatz als Ersatz für Formkörper aus Iridium verwendet werden kann. Der Formkörper soll kostengünstiger herstellbar sein als vergleichbare Formkörper aus Iridium. Gleichzeitig soll der Formkörper aber so weit wie möglich chemisch ähnlich beständig beziehungsweise resistent sein, wie Formkörper aus Iridium.

Die Aufgaben der Erfindung werden gelöst durch einen Formkörper aus einer metallischen Molybdänbasislegierung aufweisend von mindestens 3 Gew% bis maximal 8 Gew% Aluminium, von mindestens 3 Gew% bis 6 maximal Gew% Titan und als Rest Molybdän einschließlich üblicher Verunreinigungen, wobei der Formkörper direkt oder indirekt durch Erstarren aus einer Schmelze hergestellt ist.

Der Formkörper muss nicht direkt aus der Schmelze hergestellt sein. Der Formkörper kann auch als ein Zwischenprodukt durch Erstarren aus der Schmelze herstellt sein, das anschließend zur Herstellung des endgültigen Formkörpers umgeformt wird, beispielsweise durch Walzen, Ziehen oder Stanzen, so dass der Formkörper indirekt durch Erstarren aus der Schmelze hergestellt ist. Die Umformung erfolgt dabei nicht über ein Schmelzen des Zwischenprodukts. Bei der Umformung werden auch keine weiteren Legierungsbestandteile ergänzt.

Unter den üblichen Verunreinigungen werden im Rahmen der vorliegenden Erfindung herstellungsbedingte Verunreinigungen der verwendeten Elemente Molybdän, Aluminium und Titan verstanden. Diese können je nach dem geographischen Ort der Gewinnung der Rohstoffe und je nach Darstellung der Elemente Molybdän, Aluminium und Titan variieren.

Unter einer Molybdänbasislegierung wird eine metallische Legierung verstanden, die zumindest 50 at% Molybdän enthält. Bevorzugt enthält die Molybdänbasislegierung zumindest 66 at% Molybdän.

Bevorzugt ist der Formkörper ein Heizelement oder ein Werkzeug zur Verarbeitung einer Schmelze, insbesondere einer oxidischen Schmelze.

Es kann vorgesehen sein, dass die Verunreinigungen in der Summe einen Anteil von maximal 1 at% in der Molybdänbasislegierung haben, bevorzugt von maximal 0,1 at%.

Hierdurch wird sichergestellt, dass der Formkörper aus einer weitegehend reinen Molybdänbasislegierung hergestellt wird. Dadurch können negative Effekte auf die physikalischen Eigenschaften des Formkörpers und auf die mit dem Formkörper in Kontakt kommenden oxidischen Schmelzen oder andere Schmelzen oder Materialien ausgeschlossen werden.

Ferner kann vorgesehen sein, dass die Verunreinigungen als Hauptbestandteil eines oder mehrere der Elemente Zirkonium, Kohlenstoff, Hafnium, Lanthan, Yttrium, Cer, Kupfer, Rhenium, Niob, Tantal und Wolfram aufweisen.

Diese Elemente sind als Verunreinigungen häufig in den reinen Metallen Molybdän, Aluminium und Titan enthalten und können sich so auch in der über die Schmelze legierten Molybdänbasislegierung wiederfinden.

Wasserstoff und Sauerstoff können zusätzlich als Verunreinigung in der Molybdänlegierung enthalten sein, auch in Anteilen bis zu 1 at%, vorzugsweise jedoch weniger als 0,1 at%.

Ein erfindungsgemäß besonders bevorzugter Formkörper kann sich dadurch auszeichnen, dass die Molybdänbasislegierung 5,3 Gew% Aluminium ± 0,5 Gew% Aluminium und 4,7 Gew% Titan ± 0,5 Gew% Titan aufweist.

Bei dieser Zusammensetzung ist die Abdampfung von Molybdän bei gleichzeitig hohem Molybdängehalt besonders gering.

Des Weiteren kann vorgesehen sein, dass der Formkörper durch Erstarren einer Schmelze in einer Gussform hergestellt ist.

Hierdurch ist der Formkörper auch bei großen Volumina kostengünstig und mit weitgehend beliebiger äußerer Form herstellbar.

Gemäß einer Weiterbildung der vorliegenden Erfindung kann vorgesehen sein, dass der Formkörper ein Tiegel, eine Stange, eine Stange mit einer Spitze zur Verwendung als Kristallisationskeim für die Kristallzüchtung, ein Blech, eine Platte, ein Rohr, eine Heizwendel oder ein Heizstab ist.

Diese Formkörper sind für die Anwendung mit oxidischen Schmelzen und anderen Schmelzen oder als Heizelemente für Öfen, die unter Luftsauerstoff betrieben werden, besonders gut geeignet.

Bevorzugt kann ferner vorgesehen sein, dass der Formkörper ein Gewicht von zumindest 10 g hat, bevorzugt ein Gewicht von zumindest 100 g hat.

Formkörper mit einer solchen Masse sind gut als Werkzeuge einsetzbar, die mit oxidischen Schmelzen und anderen Schmelzen in unmittelbare Wechselwirkung treten, oder als Heizelemente für Öfen in Luftsauerstoff einsetzbar. Geringere Massen könnten sich zu schnell in Verbindung mit der oxidischen Schmelze oder einer anderen Schmelze oder in Verbindung mit Luftsauerstoff im Ofenraum abnutzen und unbrauchbar werden.

Es kann auch vorgesehen sein, dass der Formkörper zumindest bereichsweise eine zylindrische Außenwand aufweist.

Die Molybdänbasislegierung ist für Formkörper mit einer bereichsweisen zylindrischen Außenwand besonders gut bei einem Kontakt mit gasförmigem Luftsauerstoff, oxidischen Schmelzen oder anderen Schmelzen einsetzbar.

Des Weiteren kann vorgesehen sein, dass der Formkörper durch einen Formguss hergestellt ist.

Hierdurch ist der Formkörper besonders kostengünstig und kann in beliebiger Form hergestellt werden. Eine Nachbearbeitung kann den Formkörper in eine exaktere Form oder in eine schwerer durch Formgießen erreichbare Form bringen.

Bevorzugt kann ferner vorgesehen sein, dass der Formkörper zumindest 85 Gew% Molybdän enthält.

Der hohe Molybdängehalt ist für die Temperaturbeständigkeit maßgeblich. Die der vorliegenden Erfindung zugrundeliegenden Aufgaben werden auch gelöst durch ein

Verfahren zur Herstellung eines Formkörpers aus einer Molybdänbasislegierung aufweisend von 3 Gew% bis 8 Gew% Aluminium, von 3 Gew% bis 6 Gew% Titan und als Rest Molybdän einschließlich üblicher Verunreinigungen, gekennzeichnet durch die folgenden chronologisch nacheinander ablaufenden Schritte:
A) Herstellen einer Schmelze bestehend aus 3 Gew% bis 8 Gew% Aluminium, von 3 Gew% bis 6 Gew% Titan und als Rest Molybdän einschließlich üblicher Verunreinigungen;
B) Einfüllen der Schmelze in eine Gussform und Erstarren der Schmelze in der Gussform; und
C) Entformen des so gewonnenen Formkörpers aus der Gussform.

Dabei kann vorgesehen sein, dass mit dem Verfahren ein erfindungsgemäßer Formkörper hergestellt wird.

Ferner kann vorgesehen sein, dass in Schritt A) die Schmelze aus den reinen Metallen Molybdän, Aluminium und Titan einschließlich deren übliche Verunreinigungen erschmolzen wird, wobei bevorzugt die üblichen Verunreinigungen mit einem Anteil von weniger als 1 at% vorliegen, besonders bevorzugt mit einem Anteil von weniger als 0,1 at% vorliegen.

Hierdurch wird sichergestellt, dass der Formkörper aus einer weitgehend reinen Molybdänbasislegierung hergestellt wird. Dadurch können negative Effekte auf die physikalischen Eigenschaften des Formkörpers und auf die mit dem Formkörper in Kontakt kommenden Schmelzen und Materialien ausgeschlossen werden.

Des Weiteren kann vorgesehen sein, dass nach Schritt C) ein Schritt D) erfolgt, in dem der Formkörper umgeformt wird, bevorzugt durch Entgraten, Schneiden, Walzen, Ziehen, Polieren und/oder Fräsen umgeformt wird.

Hierdurch kann der Formkörper in eine gewünschte Form gebracht werden, die nicht oder nur schlecht direkt durch Schmelzgießen erhältlich ist.

Die der vorliegenden Erfindung zugrundeliegenden Aufgaben werden auch gelöst durch die Verwendung eines erfindungsgemäßen Formkörpers oder eines mit einem erfindungsgemäßen Verfahren hergestellten Formkörpers als Iridium-Ersatzwerkstoff.

Dieser Einsatzzweck ist für den Formkörper aus der Molybdänbasislegierung besonders sinnvoll, da er bei ähnlicher Einsetzbarkeit kostengünstiger ist als ein Formkörper aus Iridium.

Der Erfindung liegt die überraschende Erkenntnis zugrunde, dass es mit einem erfindungsgemäßen Formkörper aus einer Molybdänbasislegierung gelingt, entsprechende aber kostenaufwendige Formkörper aus Iridium zu ersetzen, wobei der Formkörper einen geringeren Verlust von Molybdän durch Abdampfen von Molybdän hat als ein Formkörper aus reinem Molybdän.

Dies wird dadurch erreicht, dass dem Problem des Abdampfens von Molybdän aus der Oberfläche des Formkörpers mit der verwendeten Legierung entgegengewirkt werden kann. Es wurde dabei überraschend gefunden, dass das Abdampfen von Molybdän durch eine an der Oberfläche des Formkörpers aus einer Molybdänbasislegierung durch eine Aluminiumoxidschicht und/oder gegebenenfalls andere Effekte verhindert werden kann, die sich bereits bei relativ geringen Aluminiumkonzentrationen in der Molybdänbasislegierung einstellt. Im Vergleich zu dem gleichen Formkörper aus reinem Molybdän hat der erfindungsgemäße Formkörper also eine höhere Lebensdauer und verursacht weniger Verunreinigungen durch abdampfendes Molybdän, wobei gleichzeitig die chemische Beständigkeit des Formkörpers dem eines Formkörpers aus reinem Molybdän entspricht. Dadurch ist der erfindungsgemäße Formkörper für viele Anwendungen besser als Ersatz für Formkörper aus Iridium geeignet als Formkörper aus reinem Molybdän oder aus anderen zu diesem Zweck bekannten Molybdänbasislegierungen.

Gemäß der vorliegenden Erfindung wird die Molybdänbasislegierung über eine Schmelze hergestellt. Als Anwendung kann beispielsweise ein Tiegel als Formkörper für Hochtemperaturanwendungen, wie die Kristallzucht für Sensoren, Laserkristalle oder Halbleiter für Dioden, verwendet werden.

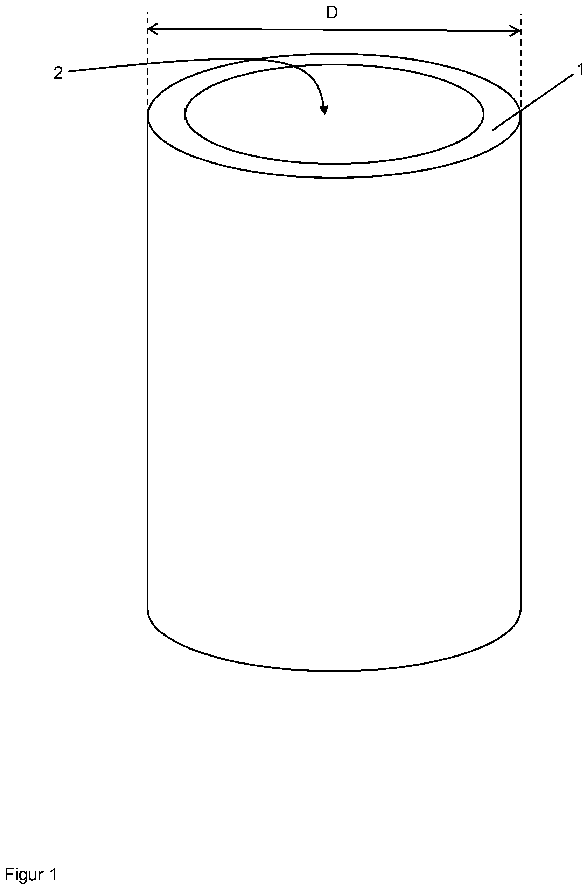

Im Folgenden werden Ausführungsbeispiele der Erfindung anhand von einer schematisch dargestellten Figur erläutert, ohne jedoch dabei die Erfindung zu beschränken. Dabei zeigt Figur 1 eine schematische perspektivische Darstellung eines erfindungsgemäßen Formkörpers.

Der Formkörper gemäß dem Ausführungsbeispiel nach Figur 1 ist ein Tiegel mit zylindrischem Außenumfang und kann eine zur Zylinderachse des Außenumfangs rotationssymmetrische Form aufweisen. Der Tiegel kann seitlich durch Wandungen 1 begrenzt sein, die eine gleichmäßige Dicke aufweisen können. Der Tiegel kann nach oben offen sein und dort eine Öffnung 2 aufweisen (siehe Figur 1 oben). Ein der gezeigten Öffnung 2 (in Figur 1 oben) gegenüberliegendes Ende des Tiegels kann mit einer flachen ebenen Bodenplatte (nicht zu sehen) verschlossen sein. Dadurch kann im Inneren des Tiegels ein Innenraum zur Aufnahme einer Schmelze ausgebildet sein, der seitliche durch die Wandungen 1 und an der Unterseite durch die Bodenplatte begrenzt sein kann.

Der Tiegel besteht vorzugsweise aus 5 bis 6 Gew% Aluminium, 4 bis 5 Gew% Titan und dem Rest aus Molybdän sowie üblichen Verunreinigungen oder aus einer anderen Molybdänbasislegierung aufweisend 3 Gew% bis 8 Gew% Aluminium und 3 Gew% bis 6 Gew% Titan sowie übliche Verunreinigungen.

Der Tiegel kann aus einer Schmelze durch Formgießen hergestellt werden. Zur Herstellung der Schmelze können die Metalle Aluminium, Titan und Molybdän in der gewünschten Zusammensetzung durch Inertgas-Druckschmelzen in einer Lichtbogenschmelzanlage aufgeschmolzen und legiert werden. Hierbei kann ein DESU-Verfahren (Druck Elektro-Schlacke Umschmelz-Verfahren) ohne Schlacke angewendet werden. Die Schmelze kann beim Abziehen aus der Flüssigkeit nach unten in der Gusskokille erstarren, um den Tiegel zu formen. Aus dem entstehenden Block kann der Tiegel durch Primär- oder Sekundärumformung hergestellt werden oder aus dem Vollen zerspanend gearbeitet werden.

Anstelle eines Tiegels, wie er in Figur 1 gezeigt ist, können mit dem gleichen Verfahren auch andere Formkörper wie Stangen, Heizwendeln und Rohr hergestellt werden. Solche Formkörper können nach dem Erstarren aus der Schmelze auch weiter umgeformt werden. Dem Fachmann sind dafür geeignete Verfahren bekannt und geläufig.

Die in der voranstehenden Beschreibung, sowie den Ansprüchen, Figuren und Ausführungsbeispielen offenbarten Merkmale der Erfindung können sowohl einzeln, als auch in jeder beliebigen Kombination für die Verwirklichung der Erfindung in ihren verschiedenen Ausführungsformen wesentlich sein.

### Bezugszeichenliste

- 1: Tiegelwandung
- 2: Öffnung
- D: Durchmesser des Tiegels

## Patentansprüche

1. Formkörper aus einer metallischen Molybdänbasislegierung aufweisend von mindestens 3 Gew% bis maximal 8 Gew% Aluminium, von mindestens 3 Gew% bis 6 maximal Gew% Titan und als Rest Molybdän einschließlich üblicher Verunreinigungen, wobei der Formkörper direkt oder indirekt durch Erstarren aus einer Schmelze hergestellt ist.

2. Formkörper nach Anspruch 1, **dadurch gekennzeichnet, dass** die Verunreinigungen in der Summe einen Anteil von maximal 1 at% in der Molybdänbasislegierung haben, bevorzugt von maximal 0,1 at%.

3. Formkörper nach Anspruch 1 oder 2, **dadurch gekennzeichnet, dass** die Verunreinigungen als Hauptbestandteil eines oder mehrere der Elemente Zirkonium, Kohlenstoff, Hafnium, Lanthan, Yttrium, Cer, Kupfer, Rhenium, Niob, Tantal und Wolfram aufweisen.

4. Formkörper nach einem der vorangehenden Ansprüche, **dadurch gekennzeichnet, dass**
die Molybdänbasislegierung 5,3 Gew% Aluminium ± 0,5 Gew% Aluminium und 4,7 Gew% Titan ± 0,5 Gew% Titan aufweist.

5. Formkörper nach einem der vorangehenden Ansprüche, **dadurch gekennzeichnet, dass**
der Formkörper durch Erstarren einer Schmelze in einer Gussform hergestellt ist.

6. Formkörper nach einem der vorangehenden Ansprüche, **dadurch gekennzeichnet, dass**
der Formkörper ein Tiegel, eine Stange, eine Stange mit einer Spitze zur Verwendung als Kristallisationskeim für die Kristallzüchtung, ein Blech, eine Platte, ein Rohr, eine Heizwendel oder ein Heizstab ist.

7. Formkörper nach einem der vorangehenden Ansprüche, **dadurch gekennzeichnet, dass**
der Formkörper ein Gewicht von zumindest 10 g hat, bevorzugt ein Gewicht von zumindest 100 g hat.

8. Formkörper nach einem der vorangehenden Ansprüche, **dadurch gekennzeichnet, dass**
der Formkörper zumindest bereichsweise eine zylindrische Außenwand aufweist.

9. Formkörper nach einem der vorangehenden Ansprüche, **dadurch gekennzeichnet, dass**
der Formkörper durch einen Formguss hergestellt ist.

10. Formkörper nach einem der vorangehenden Ansprüche, **dadurch gekennzeichnet, dass**
der Formkörper zumindest 85 Gew% Molybdän enthält.

11. Verfahren zur Herstellung eines Formkörpers aus einer Molybdänbasislegierung aufweisend von 3 Gew% bis 8 Gew% Aluminium, von 3 Gew% bis 6 Gew% Titan und als Rest Molybdän einschließlich üblicher Verunreinigungen, **gekennzeichnet durch** die folgenden chronologisch nacheinander ablaufenden Schritte:
A) Herstellen einer Schmelze bestehend aus 3 Gew% bis 8 Gew% Aluminium, von 3 Gew% bis 6 Gew% Titan und als Rest Molybdän einschließlich üblicher Verunreinigungen,
B) Einfüllen der Schmelze in eine Gussform und Erstarren der Schmelze in der Gussform, und
C) Entformen des so gewonnenen Formkörpers aus der Gussform.

12. Verfahren nach Anspruch 11, **dadurch gekennzeichnet, dass** mit dem Verfahren ein Formkörper nach einem der Ansprüche 1 bis 10 hergestellt wird.

13. Verfahren nach Anspruch 11 oder 12, **dadurch gekennzeichnet, dass** in Schritt A) die Schmelze aus den reinen Metallen Molybdän, Aluminium und Titan einschließlich deren übliche Verunreinigungen erschmolzen wird, wobei bevorzugt die üblichen Verunreinigungen mit einem Anteil von weniger als 1 at% vorliegen, besonders bevorzugt mit einem Anteil von weniger als 0,1 at% vorliegen.

14. Verfahren nach einem der Ansprüche 11 bis 13, **dadurch gekennzeichnet, dass** nach Schritt C) ein Schritt D) erfolgt, in dem der Formkörper umgeformt wird, bevorzugt durch Entgraten, Schneiden, Walzen, Ziehen, Polieren und/oder Fräsen umgeformt wird.

15. Verwendung eines Formkörpers nach einem der Ansprüche 1 bis 10 oder eines mit einem Verfahren nach einem der Ansprüche 11 oder 14 hergestellten Formkörpers als Iridium-Ersatzwerkstoff.

## Claims

1. A molded article made of a metallic molybdenum-based alloy with at least 3 wt.% up to a maximum of 8 wt.% aluminum, at least 3 wt.% up to a maximum of 6 wt.% titanium and, as the remainder, molybdenum including the usual impurities, wherein the molded article is produced directly or indirectly by means of solidification from a melt.

2. The molded article according to Claim 1, **characterized in that** the impurities have in total a proportion of a maximum of 1 at% in the molybdenum-based alloy, preferably a maximum of 0.1 at%.

3. The molded article according to Claim 1 or 2, **characterized in that** the impurities comprise zirconium, carbon, hafnium, lanthanum, yttrium, cerium, copper, rhenium, niobium, tantalum and tungsten as a main constituent of one or more of the elements.

4. The molded article according to any one of the preceding claims, **characterized in that**
the molybdenum-based alloy has 5.3 wt.% aluminum ± 0.5 wt.% aluminum and 4.7 wt.% titanium ± 0.5 wt.% titanium.

5. The molded article according to any one of the preceding claims, **characterized in that**
the molded article is produced by means of solidifying a melt in a casting mold.

6. The molded article according to any one of the preceding claims, **characterized in that**
the molded article is a crucible, a rod, a rod having a point for use as a crystal nucleus for crystal growing, a sheet, a plate, a pipe, a heating coil or a heater rod.

7. The molded article according to any one of the preceding claims, **characterized in that**
the molded article has a weight of at least 10 g, preferably a weight of at least 100 g.

8. The molded article according to any one of the preceding claims, **characterized in that**
the molded article comprises a cylindrical outer wall at least in certain areas.

9. The molded article according to any one of the preceding claims, **characterized in that**
the molded article is produced by a mold casting.

10. The molded article according to any one of the preceding claims, **characterized in that**
the molded article contains at least 85 wt.% molybdenum.

11. A method for producing a molded article from a molybdenum-based alloy with 3 wt.% to 8 wt.% aluminum, 3 wt.% to 6 wt.% titanium and, as the remainder, molybdenum including the usual impurities, **characterized by** the following chronologically successive steps:
A) producing a melt consisting of 3 wt.% to 8 wt.% aluminum, of 3 wt.% to 6 wt.% titanium and, as the remainder, molybdenum including the usual impurities,
B) pouring the melt into a casting mold and solidifying the melt in the casting mold, and
C) releasing the molded article thus obtained from the casting mold.

12. The method according to Claim 11, **characterized in that** a molded article according to any one of Claims 1 to 10 is produced with the method.

13. The method according to Claim 11 or 12, **characterized in that** in step A), the melt is melted from the pure metals molybdenum, aluminum and titanium including the usual impurities thereof, wherein the usual impurities are preferably present with a proportion of less than 1 at%, particularly preferably with a proportion of less than 0.1 at%.

14. The method according to any one of Claims 11 to 13, **characterized in that** following step C), a step D) is carried out, in which the molded article is reshaped, preferably by deburring, cutting, rolling, drawing, polishing and/or milling.

15. Use of a molded article according to any one of Claims 1 to 10 or of a molded article produced with a method according to any one of Claims 11 to 14 as an iridium replacement material.

## Revendications

1. Corps façonné constitué par un alliage métallique à base de molybdène présentant d'au moins 3 % en poids à maximum 8 % en poids d'aluminium, d'au moins 3 % en poids à maximum 6 % en poids de titane et le reste de molybdène, y compris les impuretés usuelles, le corps façonné étant fabriqué directement ou indirectement par solidification d'une masse fondue.

2. Corps façonné selon la revendication 1, **caractérisé en ce que**
la somme des impuretés représente une proportion de maximum 1 % en atome dans l'alliage à base de molybdène, de préférence de maximum 0,1 % en atome.

3. Corps façonné selon la revendication 1 ou 2, **caractérisé en ce que** les impuretés présentent, comme constituant principal, un ou plusieurs des éléments zirconium, carbone, hafnium, lanthane, yttrium, cérium, cuivre, rhénium, niobium, tantale et tungstène.

4. Corps façonné selon l'une quelconque des revendications précédentes, **caractérisé en ce que** l'alliage à base de molybdène présente 5,3 % en poids d'aluminium ± 0,5 % en poids d'aluminium et 4,7 % en poids de titane ± 0,5 % en poids de titane.

5. Corps façonné selon l'une quelconque des revendications précédentes, **caractérisé en ce que** le corps façonné est fabriqué par solidification d'une masse fondue dans un moule de coulée.

6. Corps façonné selon l'une quelconque des revendications précédentes, **caractérisé en ce que** le corps moulé est un creuset, une barre, une barre pourvue d'une pointe destinée à être utilisée comme germe de cristallisation lors de la croissance de cristaux, une tôle, une plaque, un tube, un filament chauffant ou une barre chauffante.

7. Corps façonné selon l'une quelconque des revendications précédentes, **caractérisé en ce que** le corps façonné présente un poids d'au moins 10 g, de préférence un poids d'au moins 100 g.

8. Corps façonné selon l'une quelconque des revendications précédentes, **caractérisé en ce que** le corps façonné présente, au moins par zones, une paroi externe cylindrique.

9. Corps façonné selon l'une quelconque des revendications précédentes, **caractérisé en ce que** le corps façonné est fabriqué par un moulage.

10. Corps façonné selon l'une quelconque des revendications précédentes, **caractérisé en ce que** le corps façonné contient au moins 85 % en poids de molybdène.

11. Procédé pour la fabrication d'un corps façonné constitué par un alliage à base de molybdène, présentant de 3 % en poids à 8 %en poids d'aluminium, de 3 % en poids à 6 % en poids de titane et le reste de molybdène, y compris les impuretés usuelles, **caractérisé par** les étapes suivantes se déroulant chronologiquement les unes après les autres :
A) préparation d'une masse fondue constituée par 3 % en poids à 8 %en poids d'aluminium, de 3 % en poids à 6 % en poids de titane et le reste par du molybdène, y compris les impuretés usuelles,
B) introduction de la masse fondue dans un moule de coulée et solidification de la masse fondue dans le moule de coulée et
C) démoulage du corps façonné ainsi obtenu du moule de coulée.

12. Procédé selon la revendication 11, **caractérisé en ce qu'**
un corps façonné selon l'une quelconque des revendications 1 à 10 est fabriqué à l'aide du procédé.

13. Procédé selon la revendication 11 ou 12, **caractérisé en ce que**
dans l'étape A), la masse fondue constituée par les métaux purs molybdène, aluminium et titane, y compris leurs impuretés usuelles, est fondue, les impuretés usuelles étant de préférence présentes en une proportion inférieure à 1 % en atome, de manière particulièrement préférée en une proportion inférieure à 0,1 % en atome.

14. Procédé selon l'une quelconque des revendications 11 à 13, **caractérisé en ce que** après l'étape C), une étape D) a lieu, dans laquelle le corps façonné est transformé, de préférence transformé par ébavurage, découpe, laminage, étirage, polissage et/ou fraisage.

15. Utilisation d'un corps façonné selon l'une quelconque des revendications 1 à 10 ou d'un corps façonné fabriqué à l'aide d'un procédé selon l'une quelconque des revendications 11 ou 14 comme matériau de remplacement de l'iridium.
